# EUROPEAN PATENT APPLICATION

(11) **EP 4 350 764 A1**
(43) Date of publication of application: **10.04.2024**
(21) Application number: 22199871.9
(22) Date of filing: 05.10.2022
(51) Int. Cl.: H01L 23/495

(54) **A SEMICONDUCTOR PACKAGE ASSEMBLY**

(71) Applicant: Nexperia B.V., 6534 AB Nijmegen (NL)
(72) Inventor: Böttcher, Tim, 22529 Hamburg (DE); Funke, Hans-Juergen, 22529 Hamburg (DE); Shiu, Ivan, 22529 Hamburg (DE)
(74) Representative: Pjanovic, Ilija

(57) **Abstract**

A semiconductor package assembly is proposed, consisting of a semiconductor package and a molding resin case, the semiconductor package at least comprising a lead frame having a first lead frame side and a second lead frame side opposite to the first lead frame side; a semiconductor die structure having a first die side and a second die side opposite to the first die side, the semiconductor die structure being mounted with its second die side on the first lead frame side of the lead frame, resulting in a first conductive connection; at least one bond element being connected to the first die side of the semiconductor die structure, resulting in at least one further conductive connection; with the molding resin case encapsulating at least the semiconductor die structure, the lead frame and a first part of the at least one bond element connected to the semiconductor die structure, leaving at least the second lead frame side and the other part of the at least one bond element partly exposed, wherein the at least one bond element is provided with electric field modulation structures structured to, during operation of the semiconductor package assembly, alter an electric field created between the first conductive connection and the at least further conductive connection.

## Description

### TECHNICAL FIELD

The present disclosure relates to a semiconductor package assembly consisting of a semiconductor package and a molding resin case.

### BACKGROUND OF THE DISCLOSURE

One critical property of semiconductor package assemblies for high voltage devices (> 500V) is the creepage and clearance distance of the metal parts within the package assembly. In high voltage applications the minimum creepage distance of electrical conductors is described, e.g. in IEC60664-1 and IPC2221A. The requirement for the minimum distances according to these standards is in contradiction to the trend for higher density electronics which require smaller package assemblies.

Accordingly, it is a goal of the present disclosure to provide an improved semiconductor package assembly capable of suppressing failures in case the distances as defined in the standard are violated e.g. due to limitations in package size.

### SUMMARY OF THE DISCLOSURE

According to a first example of the disclosure, is proposed, consisting of a semiconductor package and a molding resin case, the semiconductor package at least comprising a lead frame having a first lead frame side and a second lead frame side opposite to the first lead frame side; a semiconductor die structure having a first die side and a second die side opposite to the first die side, the semiconductor die structure being mounted with its second die side on the first lead frame side of the lead frame, resulting in a first conductive connection; at least one bond element being connected to the first die side of the semiconductor die structure, resulting in at least one further conductive connection; with the molding resin case encapsulating at least the semiconductor die structure, the lead frame and a first part of the at least one bond element connected to the semiconductor die structure, leaving at least the second lead frame side and the other part of the at least one bond element partly exposed, wherein the at least one bond element is provided with electric field modulation structures structured to, during operation of the semiconductor package assembly, alter an electric field created between the first conductive connection and the at least further conductive connection.

The implementation of electric field modulation structures within the encapsulation or molding resin case inside the semiconductor package body affect the electric field established between the first conductive connection and the further conductive connection and in particular causes the electric surface field lines of the electric field to be limited or reduced. The electric field modulation structures are mounted within the molding resin case, such that no parts are exposed at the semiconductor package surface. Accordingly high electric fields are limited only to areas with proper insulation and accordingly the semiconductor package is free of contacts with opposite polarity. Accordingly, in an example, the electric field modulation structures are structured to limit or reduce the electric field outside the molding resin case and preferably the electric field modulation structures are encapsulated by the molding resin case.

In a preferred example, the electric field modulation structures are manufactured from a metal and in particular are formed as a shielding plate mounted to the first part of the at least one bond element within the molding resin case.

The electric field shielding functionality is further improved as in another example, the shielding plate extends from the first part of the at least one bond element towards the lead frame.

An improved shielding can be further achieved in an example, wherein the shielding plate extends under an angle from the first part of the at least one bond element towards the lead frame and towards the exposed bond element part or towards the semiconductor die structure. In a particular application, the angle is between 45°-90°.

In a further example the free end of the shielding plate is bend in a direction towards the semiconductor die structure. All configurations of the shielding plate disclosed in this application, pushes the voltage potential present at the at least one bond element towards the edge of the semiconductor package body and prevent reliability failures due to arcing (clearance distance) or tracking (creepage distance). The free bend end of the shielding plate further alters the electric field lines between the first and the further conductive connection of the semiconductor package assembly thus providing a further prevention.

In a further example, the free bend end of the shielding plate can be provided with a bond clip or a bond wire connected with the first die side of the semiconductor die structure, thus establishing the first conductive connection within the encapsulated molding resin case.

In an additional, advantageous example, the at least one bond element itself established the first conductive connection within the encapsulated molding resin case with the semiconductor die structure as in this example the bond element may be composed as a bond clip mounted to the first die side of the semiconductor die structure.

The first conductive connection within the encapsulated molding resin case can be established in an alternative fashion, as the first part of the at least one bond element can be provided with a bond clip or a bond wire, which is connected with the first die side of the semiconductor die structure.

### BRIEF DESCRIPTION OF THE DRAWINGS

The disclosure will now be discussed with reference to the drawings, which show in:
Figures 1a and 1b a semiconductor package assembly according to the state of the art;
Figures 2a and 2b a first example of a semiconductor package assembly according to the disclosure;
Figures 3a-3c a second-third-fourth example of a semiconductor package assembly according to the disclosure;
Figures 4a-4b and 5 a fifth and six example of a semiconductor package assembly according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

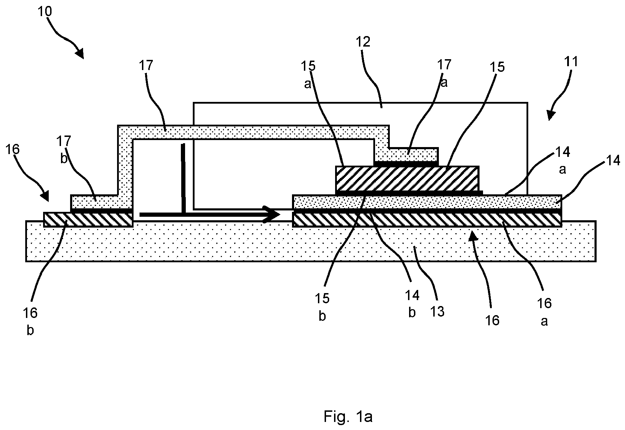

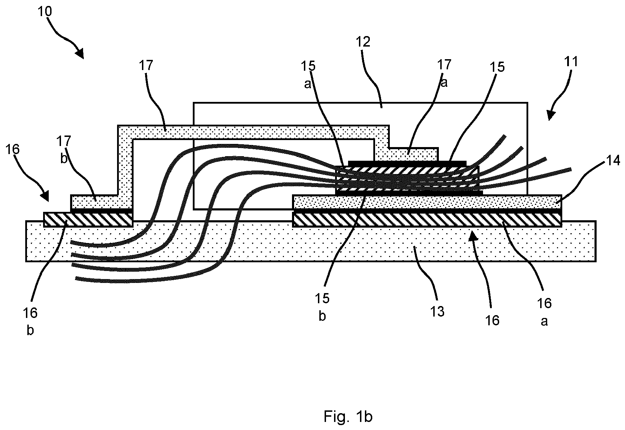

As outlined in the introduction, one critical property of semiconductor package assemblies for high voltage devices (> 500V) is the creepage and clearance distance of the metal parts within the package assembly. The requirement for the minimum distances according to these standards is in contradiction to the trend for higher density electronics which require smaller package assemblies. The adverse effects of high voltages applied in a semiconductor package assembly according to the state of the art is depicted in Figures 1a and 1b. The semiconductor package assembly according to the state of the art is denoted with reference numeral 10 and consists of a semiconductor package 11 and a molding resin case 12.

The semiconductor package 11 is composed of a lead frame 14 having a first lead frame side 14a and a second lead frame side 14b opposite to the first lead frame side 14a. A semiconductor die structure 15 has a first die side 15a and a second die side 15b opposite to the first die side 15a and is mounted with its second die side 15b on the first lead frame side 14a of the lead frame 14. In addition, at least one bond element 17 is provided which is connected with its first element part 17a to the first die side 15a of the semiconductor die structure 15.

As shown in Figures 1a and 1b, the molding resin case 12 encapsulates at least the semiconductor die structure 15, the lead frame 14 and a first part of the bond element 17 (at least comprising the first element part 17a) and leaves the other part of the bond element 17 at least comprising the other element part 17b partly exposed. Moreover, the second lead frame side 14b of the lead frame 14 is also not encapsulated by the molding resin case 12, but is exposed similar as the other element part 17b of the bond element 17. The encapsulated semiconductor die structure 15, the lead frame 14 and the bond element 17 (both its encapsulated element part 17a and exposed other element part 17b) are considered a semiconductor package assembly 10.

Such semiconductor package assembly 10 can be used in all kinds of electronics applications. To this end the semiconductor package assembly 10 can be mounted to a Printed Circuit Board, PCB, denoted with reference numeral 13.

The PCB 13 is provided with several PCB solder pads 16. In particular, reference numeral 16a denotes a PCB solder pad for the heat sink of the semiconductor package assembly 10 which heat sink is formed by the exposed second lead frame side 14b of the lead frame 14. Likewise, reference numeral 16b denotes a PCB solder pad for electrically connecting the exposed, other element part 17b of the bond element 17 with the PCB 13.

As shown in Figure 1b, during operation of the semiconductor package assembly 10 according to the state of the art, an electric field is established between the PCB solder pad 16b and the semiconductor die structure 15. The electrostatic potentials generated by this electric field may cause reliability failures due to arcing (clearance distance) or tracking (creepage distance).

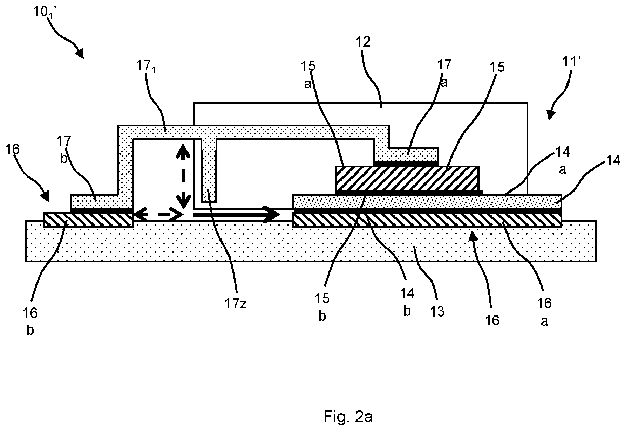

Several solutions for the above problem are presented in several examples 10₁-10₂-10₃-10₄ of the present disclosure in Figures 2a-2b, 3a-3c and 4a-4b and 5.

In these examples, reference numeral 17z denotes electric field modulation structures, which are structured to, during operation of the semiconductor package assembly 10₁-10₂-10₃-10₄, alter an electric field created between the PCB solder pad 16a and the semiconductor die structure 15. The electric field modulation structures 17z are provided with or are mounted to or are an integral part of the at least one bond element 17.

In particular, the electric field modulation structures 17z causes the electric surface field lines of the electric field E established between the solder pad 16a and the semiconductor die structure 15 to be limited or reduced. The electric field modulation structures 17z are mounted or encapsulated within the molding resin case 12, and accordingly no parts of the electric field modulation structures 17z are exposed at the surface of the semiconductor package 11. Accordingly high electric fields are limited only to areas with proper insulation and the semiconductor package 11 is free of contacts with opposite polarity. In an example, the electric field modulation structures 17z are structured to limit or reduce the electric field E outside the molding resin case 12.

It is preferred to have the electric field modulation structures 17z to be manufactured from a metal.

In all examples of Figures 2a-2b, 3a-3c, 4a-4b and 5, are the electric field modulation structures are formed as a shielding plate 17z. The shielding plate 17z is mounted to the first part of the bond element 17, which first part is encapsulated within the molding resin case 12. Accordingly, the shielding plate 17z is also completely encapsulated by the molding resin case 12 and no parts thereof are exposed at the surface of the semiconductor package 11.

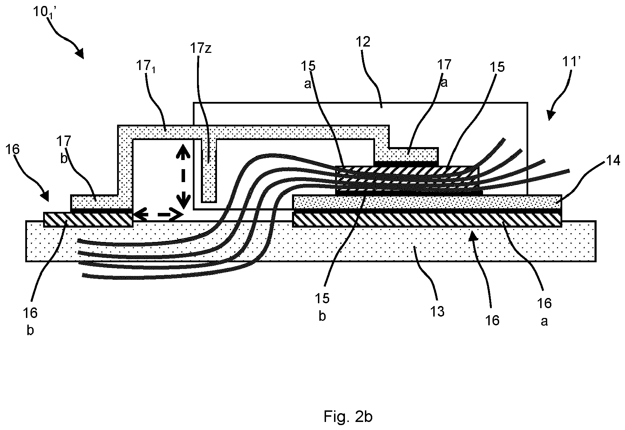

As shown in the example 10₁ of a semiconductor package assembly according to the disclosure of Figures 2a and 2b, the shielding plate 17z extends from the first part of the bond element 17 towards the lead frame 14 and the PCB 13, and provides an effective diversion of the electric field as established. In particular, the shielding plate 17z effectively prevents or limits any electric field between the shielding plate 17z and the exposed element part 17b of the bond element 17 and the semiconductor die structure 15, see Figure 2b.

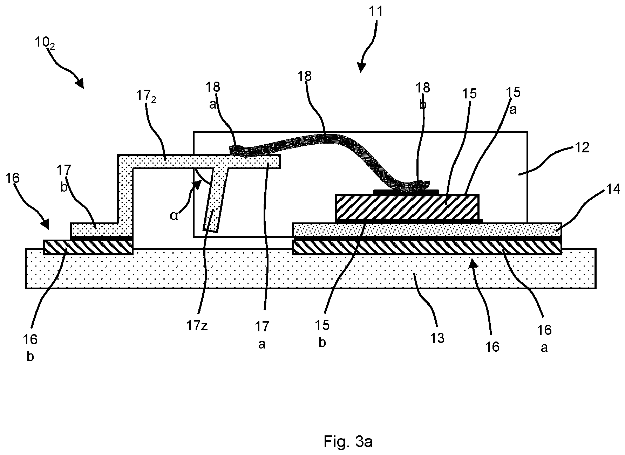

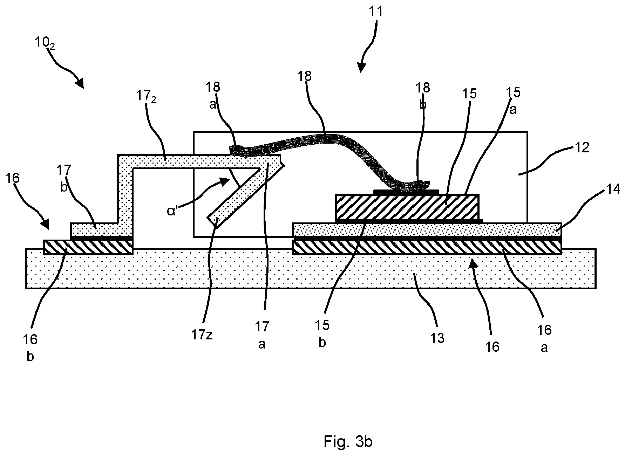

Figures 3a and 3b show the semiconductor package assembly 10₂ with further improved shielding functionalities with the shielding plate 17z extending under an angle α from the first, encapsulated element part 17a of the bond element 17₂ in a direction towards the exposed element part 17b of the bond element 17₂ and the solder pad 16b. In a particular application, the angle α is between 45°-90°, with Figure 3b showing a more acute angle α compared to the example of Figure 3a.

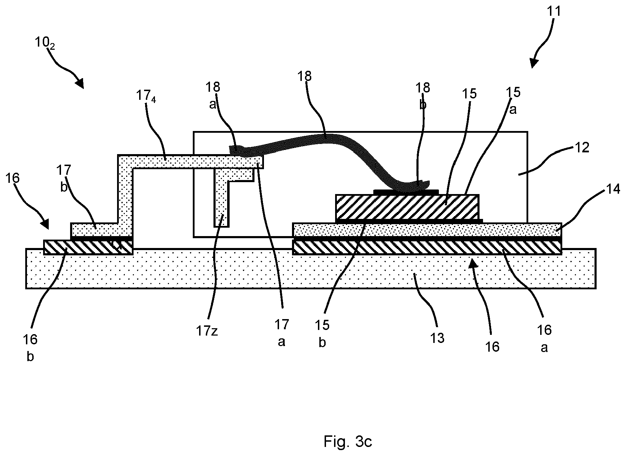

Figure 3c shows the perpendicular example (a=90°) of the shielding plate 17z relative to the bond element 17₄. In this particular example, the shielding plate 17z is soldered to the bond element 17₄.

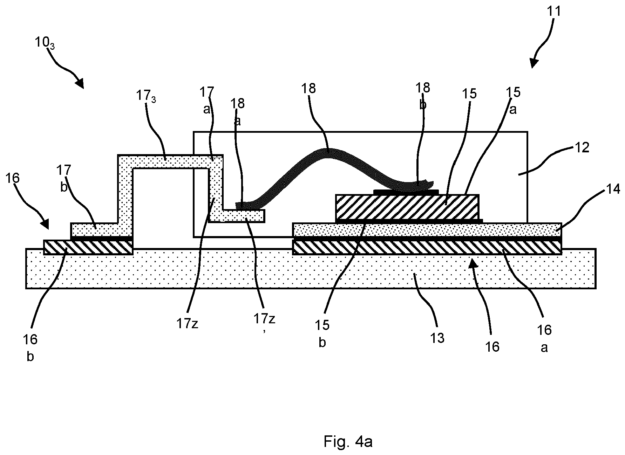

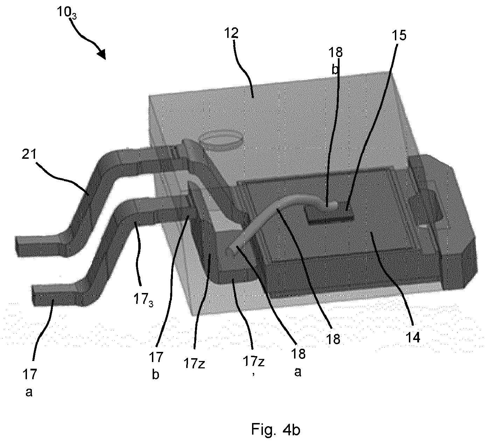

In the semiconductor package assembly example 10₃ of Figures 4a and 4b, the free end 17z' of the shielding plate 17z is bend in a direction towards the semiconductor die structure 15 and the lead frame 14. In particular, the shielding plate 17z of Figure 4a has an angle α of 90° relative to the first, encapsulated element part 17a of the bond element 17₃ whereas the free end 17z' of the shielding plate 17z is bend in a more or less 90° angle relative to the shielding plate 17z (and more or less parallel to the plane formed by the lead frame 14 / the semiconductor die structure 15). In Figure 4b, reference numeral 21 denotes a further bond element (clip), which is connected with the lead frame 14.

All configurations of the shielding plate 17z disclosed in this application, pushes the voltage potential present at the at least one bond element 17 towards the edge of the semiconductor package 11 and prevent reliability failures due to arcing (clearance distance) or tracking (creepage distance). The free bend end 17z' of the shielding plate 17z further alters the electric field lines between the first and the further conductive connection of the semiconductor package assembly 10₃ of Figures 4a-4b thus providing a further prevention.

In the semiconductor package assemblies 10₂ and 10₃ of Figures 3a-3c and 4 a bond wire 18 is used within the molding resin case 12 for establishing the first conductive connection between the bond element 17 (17₂-17₃) and the first die side 15a of the semiconductor die structure 15. In particular the bond wire 18 is connected with its first wire end 18a with the encapsulated element part 17a of the bond element 17 and with its other wire end 18b with the first die side 15a of the semiconductor die structure 15, see Figures 3a-3c.

In the example of Figures 4a and 4b, the first wire end 18a is connected with the encapsulated free bend end 17z' of the shielding plate 17z and with its other wire end 18b with the first die side 15a of the semiconductor die structure 15. In all example the bond wire 18 is fully encapsulated by the molding resin case 12, guaranteeing a stable conductive connection.

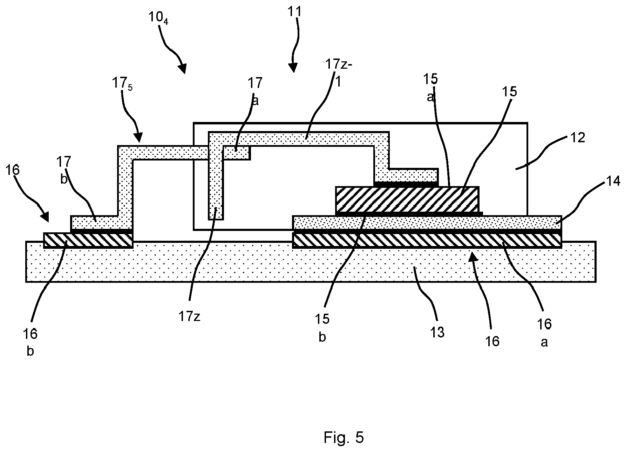

Alternatively, in the examples of Figures 3a-3c and 4a-4b, the bond wire 18 can be replaced with an additional bond clip, which establishes in a likewise manner the first conductive connection within the encapsulated molding resin case 12 between the first die side 15a of the semiconductor die structure 15 and the encapsulated element part 17a of the bond element 17 or with the encapsulated free bend end 17z' of the shielding plate 17z. In the semiconductor package assembly 10₄ of Figure 5, the bond element 17₅ is composed as a bond clip mounted with its exposed other element part 17b to the solder pad 16b. Its encapsulated first element part 17a is provided with the shielding plate 17z, which in turn has a bond clip 17z-1 incorporated therein, which is mounted or electrically connected to the first die side 15a of the semiconductor die structure 15.

In the semiconductor package assembly 10₁ of Figures 2a-2b the bond element 17₁ itself established the first conductive connection within the encapsulated molding resin case 12 with the semiconductor die structure 15. In this example, the bond element 17₁ is composed as a bond clip mounted with its encapsulated first element part 17a to the first die side 15a of the semiconductor die structure 15 and mounted with its exposed other element part 17b to the solder pad 16b.

The first conductive connection within the encapsulated molding resin case can be established in an alternative fashion, as the first part of the at least one bond element can be provided with a bond clip or a bond wire, which is connected with the first die side of the semiconductor die structure.

### LIST OF REFERENCE NUMERALS USED

- 10: semiconductor package assembly (state of the art)
- 10₁-10₅: semiconductor package assembly (examples of the disclosure)
- 11: semiconductor package
- 12: molding resin case
- 13: Printed Circuit Board (PCB)
- 14: lead frame
- 14a: first side of lead frame
- 14b: second side of lead frame
- 15: semiconductor die structure
- 15a: first die side of semiconductor die structure
- 15b: second die side of semiconductor die structure
- 16: PCB solder pad
- 16a: PCB solder pad for heat sink of package 11
- 16b: PCB solder pad for at least one lead of package 11
- 17: bond element (state of the art)
- 17₁-17₅: bond element (examples of the disclosure)
- 17a: first element part of bond element
- 17b: other element part of bond element
- 17z: electric field modulation structures / shielding plate
- α / α': angle between first part of bond element and shielding plate
- 17z': free end of shielding plate
- 17z-1: a bond clip incorporated in shielding plate
- 18: bond wire
- 18a: first wire end of bond wire
- 18b: other wire end of bond wire

## Claims

1. A semiconductor package assembly consisting of a semiconductor package and a molding resin case, the semiconductor package at least comprising:
- a lead frame having a first lead frame side and a second lead frame side opposite to the first lead frame side;
- a semiconductor die structure having a first die side and a second die side opposite to the first die side, the semiconductor die structure being mounted with its second die side on the first lead frame side of the lead frame, resulting in a first conductive connection;
- at least one bond element being connected to the first die side of the semiconductor die structure, resulting in at least one further conductive connection;
- with the molding resin case encapsulating at least the semiconductor die structure, the lead frame and a first part of the at least one bond element connected to the semiconductor die structure, leaving at least the second lead frame side and the other part of the at least one bond element partly exposed, wherein
the at least one bond element is provided with electric field modulation structures structured to, during operation of the semiconductor package assembly, alter an electric field created between the first conductive connection and the at least further conductive connection.

2. The semiconductor package assembly according to claim 1, wherein the electric field modulation structures are structured to limit or reduce the electric field outside the molding resin case.

3. The semiconductor package assembly according to claim 1 or 2, wherein the electric field modulation structures are encapsulated by the molding resin case.

4. The semiconductor package assembly according to any one or more of the preceding claims, wherein the electric field modulation structures are formed as a shielding plate mounted to the first part of the at least one bond element.

5. The semiconductor package assembly according to claim 4, wherein the shielding plate extends from the first part of the at least one bond element towards the lead frame.

6. The semiconductor package assembly according to claim 5, wherein the shielding plate extends under an angle from the first part of the at least one bond element towards the exposed bond element part or towards the semiconductor die structure.

7. The semiconductor package assembly according to claim 6, wherein the angles is between 45°-90°.

8. The semiconductor package assembly according to any one or more of the claims 4-7, wherein the free end of the shielding plate is bend in a direction towards the semiconductor die structure.

9. The semiconductor package assembly according to claim 8, wherein the bend free end of the shielding plate is provided with a bond clip or a bond wire connected with the first die side of the semiconductor die structure.

10. The semiconductor package assembly according to any one or more of the claims 1-9, wherein the at least one bond element is composed as a bond clip mounted to the first die side of the semiconductor die structure.

11. The semiconductor package assembly according to any one or more of the claims 1-10, wherein the first part of the at least one bond element is provided with a bond clip or a bond wire connected with the first die side of the semiconductor die structure.
